# FASCICULE DE BREVET EUROPEEN

(11) **EP 1 099 311 B1**
(45) Date de publication et mention de la délivrance du brevet: **13.03.2002**
(21) Numéro de dépôt: 99950814.6
(22) Date de dépôt: 22.10.1999
(51) Int. Cl.: H03M 3/02

(54) **COMPENSATION DU RETARD DU CONVERTISSEUR ANALOGIQUE-NUMERIQUE DANS LES MODULATEURS SIGMA-DELTA**
VERZÖGERUNGSKOMPENSATION DES A/D WANDLERS IN SIGMA-DELTA MODULATOREN
DELAY COMPENSATION FOR ANALOG-TO-DIGITAL CONVERTER IN SIGMA-DELTA MODULATORS

(30) Priorité: 23.10.1998 FR 9813324
(43) Date de publication de la demande: 16.05.2001
(73) Titulaire: Thales, 75008 Paris (FR)
(72) Inventeur: DE GOUY, Jean-Luc, Thomson-CSF Prop. Intellect., 94117 Arcueil Cedex (FR); GABET, Pascal, Thomson-CSF Prop. Intellect., 94117 Arcueil Cedex (FR); BENABES, Philippe, Thomson-CSF Prop. Intellect., 941117 Arcueil Cedex (FR)
(74) Mandataire: Vigand, Régis Louis Michel
(86) Numéro de dépôt international: FR9902579
(87) Numéro de publication internationale: WO0025428

(56) Documents cités:
- US-A- 5 668 552
- US-A- 5 757 301

## Description

L'invention concerne le domaine des modulateurs sigma-delta. Classiquement un modulateur sigma-delta comporte un bloc d'amplification, un convertisseur analogique-numérique et un convertisseur numérique-analogique. Le modulateur rend plus lente mais plus précise la fonction de conversion analogique-numérique du convertisseur analogique-numérique contenu dans le modulateur, en diminuant le bruit de quantification du convertisseur analogique-numérique. Le modulateur peut se décomposer en une chaîne directe comportant le bloc d'amplification et le convertisseur analogique-numérique, et en une boucle de rétroaction comportant le convertisseur numérique-analogique.

Un modulateur sigma-delta performant présente un gain de valeur élevée. En effet, le bruit de quantification peut être réduit d'un facteur sensiblement égal à ce gain. Cependant la valeur du gain est limitée par des contraintes de stabilité du modulateur. La condition fondamentale de stabilité d'un système possédant une boucle de rétroaction peut s'énoncer ainsi : la phase du système doit être supérieure à -180 degrés lorsque le gain du système en fonction de la fréquence vaut zéro décibel. Or un retard de propagation du signal au sein du système a pour effet de diminuer sa phase, donc de dégrader la stabilité. Par conséquent un retard de propagation entre l'entrée du convertisseur analogique-numérique et la sortie du convertisseur numérique-analogique a pour effet de dégrader cette stabilité, voire d'entraîner une instabilité du modulateur. Un des objets de l'invention est de proposer un modulateur sigma-delta permettant de compenser les effets, sur la stabilité du modulateur, du retard de propagation entre l'entrée du convertisseur analogique-numérique et la sortie du convertisseur numérique-analogique. Ce modulateur sigma-delta permet de compenser le retard du convertisseur analogique-numérique et le retard du convertisseur numérique-analogique.

Pour cela, une première solution de l'art antérieur consiste à diminuer le gain du modulateur de manière à ce que le modulateur soit stable malgré le retard de propagation. Mais cette diminution de gain entraîne une diminution de performances du modulateur, notamment en termes de réduction du bruit de quantification.

Une deuxième solution de l'art antérieur consiste à diminuer la fréquence d'échantillonnage interne du modulateur afin de masquer le retard de propagation. La fréquence d'échantillonnage interne du modulateur sera souvent la fréquence d'échantillonnage des convertisseurs. Le taux de suréchantillonnage étant le rapport entre la fréquence de sortie des informations du modulateur et la fréquence d'échantillonnage interne du modulateur, à fréquence de sortie donnée la diminution de la fréquence d'échantillonnage interne correspond à une diminution du taux de suréchantillonnage. Or la diminution du taux de suréchantillonnage se traduit également par une diminution de gain avec les mêmes inconvénients que pour la première solution de l'art antérieur.

Le document US 5 668 552 concerne un convertisseur analogique-numérique sigma-delta comportant au moins trois étages de filtrage, dont le bruit de quantification peut-être réduit par augmentation du nombre d'étages de filtrage.

L'invention propose un modulateur comportant un filtre de compensation permettant de compenser le retard de propagation entre l'entrée du convertisseur analogique-numérique et la sortie du convertisseur numérique-analogique. Ce filtre de compensation permet de conserver la réponse impulsionnelle qu'aurait le modulateur en l'absence de retard de propagation. Comme il y a correspondance biunivoque entre la réponse impulsionnelle du modulateur et le gain du modulateur en fonction de la fréquence, ce filtre de compensation permet également de conserver le gain en fonction de la fréquence qu'aurait le modulateur en l'absence de retard de propagation. Pour cela, le filtre de compensation reconstitue le début de cette réponse impulsionnelle non disponible par suite du retard de propagation.

Selon l'invention, il est prévu un modulateur sigma-delta ayant une borne d'entrée et une bome de sortie, comportant :
- une chaîne directe reliant la borne d'entrée du modulateur à la borne de sortie du modulateur et comportant successivement, un bloc d'amplification comportant une fonction amplification de gain supérieur à l'unité sur un domaine de fréquences prédéterminé, la borne d'entrée du modulateur étant reliée à une première entrée directe du bloc d'amplification, et un convertisseur analogique-numérique ;
- une boucle de rétroaction reliant la sortie du convertisseur analogique-numérique à une deuxième entrée inverseuse du bloc d'amplification et comportant un convertisseur numérique-analogique ;
et présentant un retard Δt de propagation entre l'entrée du convertisseur analogique-numérique et la sortie du convertisseur numérique-analogique ;
caractérisé en ce que le modulateur sigma-delta comporte aussi :
- un soustracteur situé dans la chaîne directe entre le bloc d'amplification et le convertisseur analogique-numérique, la sortie du bloc d'amplification étant reliée à une première entrée directe du soustracteur, une sortie du soustracteur étant reliée à l'entrée du convertisseur analogique-numérique ;
- un filtre de compensation situé entre la sortie du soustracteur et une deuxième entrée inverseuse du soustracteur ;
et en ce que si on considère une réponse impulsionnelle du modulateur au niveau de la sortie du soustracteur, à une impulsion envoyée au niveau de la sortie du soustracteur, comportant une première partie couvrant un premier intervalle de temps [ *0* ; *T* [ avec *T≥Δt* et une deuxième partie couvrant un deuxième intervalle de temps [ *T* ; ∞ [, le filtre de compensation est prévu pour contribuer à la première partie et le bloc d'amplification est prévu pour ne contribuer qu'à la deuxième partie.

L'invention sera mieux comprise et d'autres caractéristiques et avantages apparaîtront à l'aide de la description ci-après et des dessins joints, donnés à titre d'exemples non limitatifs, où :
- la figure 1 représente schématiquement une réalisation d'un modulateur sigma-delta selon l'invention.
- les figures 2A et 2B représentent schématiquement les contributions à la réponse impulsionnelle du modulateur, respectivement du filtre de compensation et du bloc d'amplification.
- la figure 2C représente schématiquement la réponse impulsionnelle du modulateur.
- la figure 3 représente schématiquement une réalisation du filtre de compensation d'un modulateur sigma-delta selon l'invention.

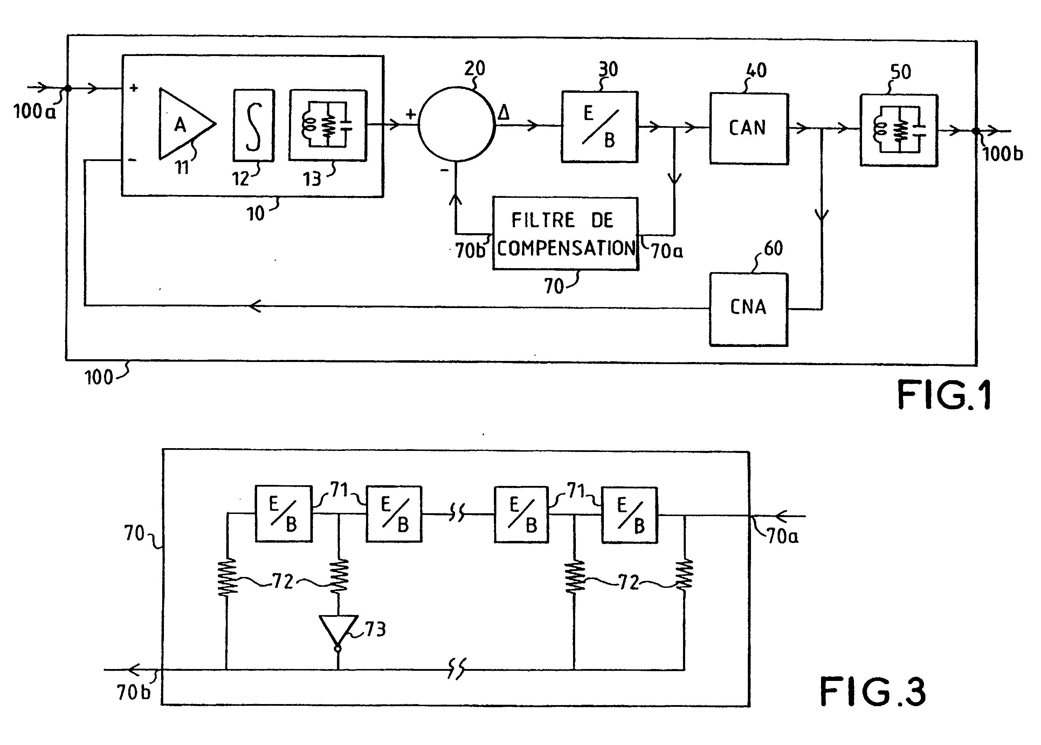

La figure 1 représente une réalisation d'un modulateur 100 sigma-delta. Les flèches indiquent le sens de propagation du signal, de préférence une tension, dans le modulateur. Ce modulateur 100 comporte une borne d'entrée 100a et une borne de sortie 100b. La tension de sortie au niveau de la borne de sortie 100b représente la tension d'entrée au niveau de la borne d'entrée 100a, quantifiée et multipliée par un gain de préférence variable en fonction de la fréquence. La borne d'entrée 100a est reliée à la première entrée directe, notée + sur la figure 1, d'un bloc 10 d'amplification. La sortie du bloc 10 est reliée à une première entrée directe, notée + sur la figure 1, d'un soustracteur 20. La sortie, notée Δ sur la figure 1, du soustracteur 20 est reliée à l'entrée d'un convertisseur analogique-numérique 40, soit directement soit de préférence par l'intermédiaire d'un échantillonneur-bloqueur 30 dans le cas de la figure 1 correspondant à un mode de fonctionnement en temps dit « continu ». On pourrait également envisager par exemple une fonction échantillonnage-bloquage intégrée au convertisseur analogique-numérique 40. Dans un mode de fonctionnement en temps dit « discret », l'échantillonneur-bloqueur 30 pourrait se trouver en amont de la borne d'entrée 100a. La sortie du convertisseur analogique-numérique 40 est reliée à la borne de sortie 100b, soit directement, soit de préférence par l'intermédiaire d'un filtre 50 de découpage. La chaîne directe est le circuit reliant la borne d'entrée 100a à la borne de sortie 100b en passant successivement par la première entrée directe du bloc 10, la sortie du bloc 10, la première entrée directe du soustracteur 20, la sortie du soustracteur 20, l'échantillonneur-bloqueur 30, le convertisseur analogique-numérique 40, le filtre 50 de découpage.

La sortie du convertisseur analogique-numérique 40 est également reliée à l'entrée d'un convertisseur numérique-analogique 60. La sortie du convertisseur numérique-analogique 60 est reliée à une deuxième entrée inverseuse, notée - sur la figure 1, du bloc 10 d'amplification. La boucle de rétroaction est le circuit reliant la sortie du convertisseur analogique-numérique 40 à la deuxième entrée inverseuse du bloc 10 d'amplification, en passant par le convertisseur numérique-analogique 60.

Il existe un retard Δt de propagation du signal entre l'entrée du convertisseur analogique-numérique 40 et la sortie du convertisseur numérique-analogique 60.

Entre la sortie du soustracteur 20 et la deuxième entrée inverseuse du soustracteur 20 se trouve un filtre 70 de compensation ayant une entrée 70a et une sortie 70b. L'entrée 70a du filtre 70 de compensation est reliée à la sortie du soustracteur 20, soit directement soit de préférence par l'intermédiaire de l'échantillonneur-bloqueur 30 lorsque celui-ci se trouve entre la sortie du soustracteur 20 et l'entrée du convertisseur analogique-numérique 40.

Le bloc 10 d'amplification comporte une fonction amplification 11. Selon l'application envisagée, le bloc 10 d'amplification comporte aussi de préférence, une fonction intégration 12 par rapport au temps et/ou un filtre 13 de mise en forme du gain de la fonction amplification 11. Le bloc 10 a deux entrées, une première entrée directe qui ne modifie pas la tension arrivant de la borne d'entrée 100a, et une deuxième entrée inverseuse qui inverse le signe de la tension arrivant de la sortie du convertisseur numérique-analogique 60. La tension de sortie du bloc 10 est obtenue à partir des tensions présentes sur les deux entrées du bloc 10, par la réalisation de plusieurs fonctions contenues dans le bloc 10. La fonction amplification 11 possède un gain d'amplification G en fonction de la fréquence. Sur un domaine de fréquences prédéterminé dépendant de l'application envisagée, le gain G est supérieur à l'unité. Ce gain G est de préférence très grand devant l'unité, par exemple de l'ordre d'un facteur cent ou d'un facteur mille. Le gain G doit également respecter les conditions de stabilité communes à tous les modulateurs sigma-delta. Le bloc 10 comporte de préférence un filtre 13 de mise en forme du gain G de la fonction amplification 11 en fonction de la fréquence. L'agencement et le contenu particulier de ces fonctions dépend de l'application envisagée.

Le soustracteur 20 effectue la différence entre sa première entrée directe et sa deuxième entrée inverseuse. La sortie du soustracteur 20 vaut cette différence. L'échantillonneur-bloqueur 30 et le convertisseur analogique-numérique 40 sont de préférence pilotés par la même fréquence d'échantillonnage. Le filtre 50 de découpage découpe une zone utile dans le domaine de fréquences prédéterminé. Cette zone utile dépend de l'application envisagée. Le filtre 50 est par exemple du type passe-bas jusqu'à deux mégahertz ou par exemple du type passe-bande avec dix mégahertz de bande.

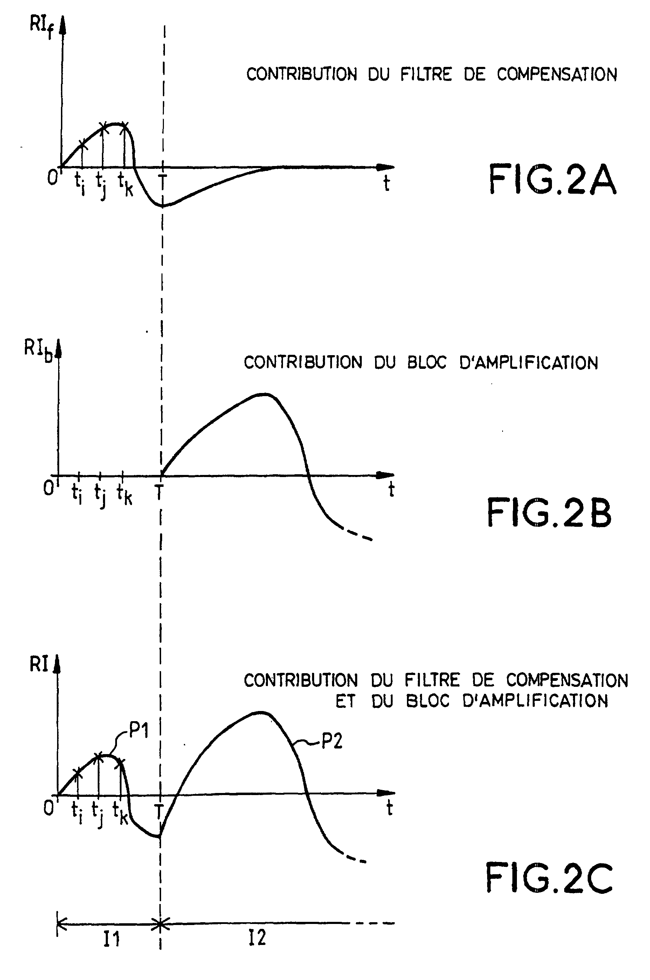

On considère les figures 2A à 2C. Une impulsion est envoyée au niveau de la sortie du soustracteur 20. Soit RI la réponse impulsionnelle du modulateur 100 au niveau de la sortie du soustracteur 20. Les figures 2A et 2B représentent les contributions Rl_{f} et Rl_{b} à la réponse impulsionnelle RI du modulateur 100 représentée sur la figure 2C, respectivement du filtre 70 de compensation et du bloc 10. Soit une application particulière demandant la réponse impulsionnelle RI représentée sur la figure 2C. Cette réponse impulsionnelle RI ne peut pas être obtenue directement par une configuration particulière du bloc 10 comme dans l'art antérieur à cause du retard Δt de propagation. En effet, avant l'instant Δt, l'impulsion envoyée à l'instant 0 au niveau de la sortie du soustracteur 20 n'est pas encore parvenue au niveau de la deuxième entrée inverseuse du bloc 10. Toute la partie de la réponse impulsionnelle Rl comprise entre l'instant 0 et l'instant Δt n'est donc pas disponible à la sortie du bloc 10. Soit T un temps supérieur ou égal au retard de propagation Δt, T est de préférence sensiblement égal au retard Δt additionné notamment des retards respectifs de l'échantillonneur-bloqueur 30 et du bloc 10. I1 est l'intervalle de temps compris entre l'instant 0 et l'instant T, T étant exclu de l'intervalle. 12 est l'intervalle de temps compris entre l'instant T, T étant inclus dans l'intervalle, et la fin de l'axe des temps qu'on appelle ∞. P1 est la première partie de la réponse impulsionnelle RI sur l'intervalle I1. P2 est la deuxième partie de la réponse impulsionnelle RI sur l'intervalle I2.

Le retard Δt de propagation peut être de l'ordre de une à plusieurs périodes d'échantillonnage interne, typiquement par exemple de une à trois. En cas de non compensation du retard Δt de propagation, le déphasage du gain G, dans la zone de fréquences où le gain G vaut zéro décibel, dépasse 180 degrés et le modulateur 100 devient instable. Le modulateur selon l'invention est d'autant plus intéressant que le convertisseur analogique-numérique 40 est rapide. En effet, plus la fréquence d'échantillonnage interne est élevée, plus le retard Δt de propagation vaut un multiple élevé de périodes d'échantillonnage interne, et plus il est crucial de compenser ce retard Δt de propagation.

Le filtre 70 de compensation, qui n'est pas soumis au retard de propagation Δt, génère la première partie P1 de la réponse impulsionnelle RI, il peut également contribuer à la deuxième partie P2. La contribution RI_{f} du filtre 70 de compensation est représentée sur la figure 2A. La contribution Rl_{b} du bloc 10 à la réponse impulsionnelle RI est représentée sur la figure 2B. Le bloc 10 ne contribue qu'à la deuxième partie P2. La somme des contributions Rl_{f} et Rl_{b} donne la réponse impulsionnelle RI du modulateur représentée sur la figure 2C. Les instants ti, tj, tk représentent des instants d'échantillonnage dans le cas préférentiel de la figure 1 comportant l'échantillonneur-bloqueur 30. Dans ce cas là par exemple, seules les valeurs de la réponse impulsionnelle RI aux instants d'échantillonnage sont importantes : hors de ces instants d'échantillonnage, la réponse impulsionnelle RI pourrait prendre des valeurs quelconques. Cependant, de préférence, la contribution Rl_{f} du filtre 70 de compensation à la première partie P1 de la réponse impulsionnelle RI est prévue pour éviter des sauts de tension trop brusques à l'entrée de l'échantillonneur-bloqueur 30 hors des instants d'échantillonnage. Le filtre 70 de compensation est alors réalisé en temps dit « continu », c'est-à-dire sous la forme d'un filtre agissant de manière continue dans le temps, par exemple sous forme d'un filtre passif du type filtre R,L,C ou bien sous forme d'un filtre actif.

Le modulateur sigma-delta utilise de préférence un convertisseur analogique-numérique 40 rapide et ayant peu de bits, donc pas trop coûteux. Ce convertisseur à faible nombre de bits est sujet à un bruit de quantification important, il est donc peu précis. Un des intérêts du modulateur sigma-delta est de réaliser à partir d'un convertisseur analogique-numérique 40 rapide et peu précis, une conversion analogique-numérique plus lente, ayant habituellement une bande de fréquences plus étroite, mais ayant une résolution plus grande. Par rapport à la résolution du convertisseur analogique-numérique 40, la résolution obtenue peut être améliorée d'un facteur sensiblement égal au gain G lorsque celui-ci est très supérieur à l'unité. Lorsque le gain G vaut cent par exemple, la résolution peut être augmentée d'un facteur cent.

Si K est le gain d'amplification du filtre 70 de compensation en fonction de la fréquence, la résolution du modulateur 100 ne peut être améliorée que dans un facteur valant approximativement G/K dès que K est sensiblement supérieur à l'unité. Préférentiellement, la contribution Rl_{f} du filtre 70 de compensation à la deuxième partie P2 de la réponse impulsionnelle RI est prévue pour minimiser le gain K sur la zone utile du domaine de fréquences prédéterminé, ce qui permet d'améliorer la résolution du modulateur 100.

La figure 3 représente une réalisation, dans le cas préférentiel de la figure 1 utilisant un échantillonneur-bloqueur 30, du filtre 70 de compensation ; cette réalisation est en temps dit « discret », c'est-à-dire sous la forme d'un filtre n'agissant qu'aux instants d'échantillonnage de l'échantillonneur-bloqueur 30. Le filtre 70 de compensation comporte un ou plusieurs échantillonneurs-bloqueurs 71. Les échantillonneurs-bloqueurs 71, lorsqu'ils sont plusieurs, sont en série entre l'entrée 70a et la sortie 70b. Les traits en lignes brisées indiquent que le nombre d'échantillonneurs-bloqueurs 71 n'est pas limité aux quatre éléments représentés sur la figure 3. Entre l'entrée 70a, reliée à la sortie de l'échantillonneur-bloqueur 30, et la sortie 70b se trouvent une résistance 72 et éventuellement un inverseur 73. Entre chaque sortie d'échantlllonneur-bloqueur 71 et la sortie 70b se trouvent une résistance 72 et éventuellement un inverseur 73. Les inverseurs 73 et les résistances 72 permettent de constituer la première partie P1 de la réponse impulsionnelle RI aux instants d'échantillonnage, chaque résistance 72 et éventuellement chaque inverseur 73 servant à pondérer la réponse impulsionnelle RI à chaque instant d'échantillonnage. Les échantillonneurs-bloqueurs 71 sont pilotés par la même fréquence d'échantillonnage que l'échantillonneur-bloqueur 30, et ils sont en nombre suffisant pour permettre de constituer toute la première partie P1.

Un modulateur sigma-delta avec un filtre 70 de compensation peut être utilisé par exemple dans une chaîne de traitement radar.

## Revendications

1. Modulateur sigma-delta ayant une borne d'entrée (100a) et une borne de sortie (100b), comportant :
- une chaîne directe reliant la borne d'entrée (100a) du modulateur (100) à la borne de sortie (100b) du modulateur (100) et comportant successivement un bloc (10) d'amplification comportant une fonction amplification (11) de gain (G) supérieur à l'unité sur un domaine de fréquences prédéterminé, la borne d'entrée (100a) du modulateur (100) étant reliée à une première entrée directe du bloc (10) d'amplification, et un convertisseur analogique-numérique (40) ;
- une boucle de rétroaction reliant la sortie du convertisseur analogique-numérique (40) à une deuxième entrée inverseuse du bloc (10) d'amplification et comportant un convertisseur numérique-analogique (60) ;
et présentant un retard *Δt* de propagation entre l'entrée du convertisseur analogique-numérique (40) et la sortie du convertisseur numérique-analogique (60) ;
**caractérisé en ce que** le modulateur (100) sigma-delta comporte aussi :
- un soustracteur (20) situé dans la chaîne directe entre le bloc (10) d'amplification et le convertisseur analogique-numérique (40), la sortie du bloc (10) d'amplification étant reliée à une première entrée directe du soustracteur (20), une sortie du soustracteur (20) étant reliée à l'entrée du convertisseur analogique-numérique (40) ;
- un filtre (70) de compensation situé entre la sortie du soustracteur (20) et une deuxième entrée inverseuse du soustracteur (20) ;
et **en ce que** si on considère une réponse impulsionnelle (RI) du modulateur (100) au niveau de la sortie du soustracteur (20), à une impulsion envoyée au niveau de la sortie du soustracteur (20), comportant une première partie (P1) couvrant un premier intervalle (I1) de temps [0 ; T [ avec *T≥Δt* et une deuxième partie (P2) couvrant un deuxième intervalle (I2) de temps [ *T* ; ∞ [, le filtre (70) de compensation est prévu pour contribuer à la première partie (P1) et le bloc (10) d'amplification est prévu pour ne contribuer qu'à la deuxième partie (P2).

2. Modulateur selon la revendication 1, **caractérisé en ce que** la chaîne directe comporte, entre la sortie du convertisseur analogique-numérique (40) et la borne de sortie (100b) du modulateur (100), un filtre (50) de découpage d'une zone utile dans le domaine de fréquences prédéterminé.

3. Modulateur selon la revendication 2, **caractérisé en ce que** le filtre (70) de compensation est en outre prévu pour contribuer à la deuxième partie (P2) de la réponse impulsionnelle (RI) de manière à avoir un gain (K) d'amplification du filtre (70) de compensation dans la zone utile qui soit minimum.

4. Modulateur selon l'une quelconque des revendications précédentes, **caractérisé en ce que** la chaîne directe comporte un échantillonneur-bloqueur (30) piloté par une fréquence d'échantillonnage et situé entre la sortie du soustracteur (20) et l'entrée du convertisseur analogique-numérique (40), l'entrée (70a) du filtre (70) de compensation étant reliée à la sortie de l'échantillonneur-bloqueur (30).

5. Modulateur selon la revendication 4, **caractérisé en ce que** le filtre (70) de compensation comporte, à partir de la sortie de l'échantillonneur-bloqueur (30), un ou plusieurs échantillonneurs-bloqueurs (71) en série, des résistances (72) situées entre les sorties des échantillonneurs-bloqueurs (30, 71) et la deuxième entrée inverseuse du soustracteur (20), les échantillonneurs-bloqueurs (30, 71) étant pilotés par la même fréquence d'échantillonnage.

6. Modulateur selon la revendication 5, **caractérisé en ce qu'**au moins une des dites résistances (72) est reliée à la deuxième entrée inverseuse du soustracteur (20) par un inverseur (73).

7. Modulateur selon la revendication 4, **caractérisé en ce que** hors des instants d'échantillonnage (ti, tj, tk) de l'échantillonneur-bloqueur (30), le filtre (70) de compensation est constitué de manière à contribuer à la première partie (P1) de la réponse impulsionnelle (RI) en évitant des sauts de tension à l'entrée de l'échantillonneur-bloqueur (30).

8. Modulateur selon l'une des revendications précédentes, **caractérisé en ce que** le bloc (10) d'amplification comporte un filtre (13) de mise en forme du gain de la fonction amplification (11) en fonction de la fréquence.

9. Modulateur selon l'une des revendications précédentes, **caractérisé en ce que** la fonction amplification (11) a un gain supérieur à un facteur cent.

## Patentansprüche

1. Sigma-Delta-Modulator, der einen Eingangsanschluß (100a) und einen Ausgangsanschluß (100b) besitzt und umfaßt:
- eine direkte Kette, die den Eingangsanschluß (100a) des Modulators (100) mit dem Ausgangsanschluß (100b) des Modulators (100) verbindet und nacheinander einen Verstärkungsblock (10), der eine Verstärkungsfunktion (11) mit einem Verstärkungsfaktor (G), der in einem vorgegebenen Frequenzbereich größer als eins ist, besitzt, wobei der Eingangsanschluß (100a) des Modulators (100) mit einem ersten direkten Eingang des Verstärkungsblocks (10) verbunden ist, und einen Analog/Digital-Umsetzer (40) umfaßt;
- eine Rückkopplungsschleife, die den Ausgang des Analog/Digital-Umsetzers (40) mit einem zweiten invertierenden Eingang des Verstärkungsblocks (10) verbindet und einen Digital/Analog-Umsetzer (60) enthält;
und eine Ausbreitungsverzögerung Δt zwischen dem Eingang des Analog/Digital-Umsetzers (40) und dem Ausgang des Digital/Analog-Umsetzers (60) aufweist;
**dadurch gekennzeichnet, daß** der Sigma-Delta-Modulator (100) außerdem umfaßt:
- einen Subtrahierer (20), der sich in der direkten Kette zwischen dem Verstärkungsblock (10) und dem Analog/Digital-Umsetzer (40) befindet, wobei der Ausgang des Verstärkungsblocks (10) mit einem ersten direkten Eingang des Subtrahierers (20) verbunden ist und ein Ausgang des Subtrahierers (20) mit dem Eingang des Analog/Digital-Umsetzers (40) verbunden ist;
- ein Kompensationsfilter (70), das sich zwischen dem Ausgang des Subtrahierers (20) und einem zweiten invertierenden Eingang des Subtrahierers (20) befindet;
und daß bei Betrachtung einer Impulsantwort (RI) des Modulators (100) auf Höhe des Ausgangs des Subtrahierers (20) bei einem auf Höhe des Ausgangs des Subtrahierers (20) geschickten Impuls, der einen ersten Teil (P1), der ein erstes Zeitintervall (I1) [0; T[, mit T ≥ Δt, abdeckt, und einen zweiten Teil (P2), der ein zweites Zeitintervall (12) [T; ∞[ abdeckt, enthält, das Kompensationsfilter (70) dazu vorgesehen ist, zum ersten Teil (P1) beizutragen, und der Verstärkungsblock (10) dazu vorgesehen ist, nur zum zweiten Teil (P2) beizutragen.

2. Modulator nach Anspruch 1, **dadurch gekennzeichnet, daß** die direkte Kette zwischen dem Ausgang des Analog/Digital-Umsetzers (40) und dem Ausgangsanschluß (100b) des Modulators (100) ein Filter (50) zum Ausschneiden einer Nutzzone in dem vorgegebenen Frequenzbereich umfaßt.

3. Modulator nach Anspruch 2, **dadurch gekennzeichnet, daß** das Kompensationsfilter (70) außerdem dazu vorgesehen ist, zum zweiten Teil (P2) der Impulsantwort (RI) in der Weise beizutragen, daß in der Nutzzone ein minimaler Verstärkungsfaktor (K) des Kompensationsfilters (70) erhalten wird.

4. Modulator nach einem der vorhergehenden Ansprüche, **dadurch gekennzeichnet, daß** die direkte Kette eine Abtast/Halte-Schaltung (30) umfaßt, die durch eine Abtastfrequenz gesteuert wird und sich zwischen dem Ausgang des Subtrahierers (20) und dem Eingang des Analog/Digital-Umsetzers (40) befindet, wobei der Eingang (70a) des Kompensationsfilters (70) mit dem Ausgang der Abtast/Halte-Schaltung (30) verbunden ist.

5. Modulator nach Anspruch 4, **dadurch gekennzeichnet, daß** das Kompensationsfilter (70) beginnend beim Ausgang der Abtast/Halte-Schaltung (30) eine oder mehrere in Reihe geschaltete Abtast/Halte-Schaltungen (71) und Widerstände (72), die sich zwischen den Ausgängen der Abtast/Halte-Schaltungen (30, 71) und dem zweiten invertierenden Eingang des Subtrahierers (20) befinden, umfaßt, wobei die Abtast/Halte-Schaltungen (30, 71) mit derselben Abtastfrequenz gesteuert werden.

6. Modulator nach Anspruch 5, **dadurch gekennzeichnet, daß** wenigstens einer der Widerstände (72) über einen Inverter (73) mit dem zweiten invertierenden Eingang des Subtrahierers (20) verbunden ist.

7. Modulator nach Anspruch 4, **dadurch gekennzeichnet, daß** das Kompensationsfilter (70) außerhalb der Abtastzeitpunkte (ti, tj, tk) der Abtast/Halte-Schaltung (30) so aufgebaut ist, daß es zum ersten Teil (P1) der Impulsantwort (RI) beiträgt, indem es am Eingang der Abtast/Halte-Schaltung (30) Spannungssprünge vermeidet.

8. Modulator nach einem der vorhergehenden Ansprüche, **dadurch gekennzeichnet, daß** der Verstärkungsblock (10) ein Filter (13) zur Formung des Verstärkungsfaktors der Verstärkungsfunktion (11) in Abhängigkeit von der Frequenz umfaßt.

9. Modulator nach einem der vorhergehenden Ansprüche, **dadurch gekennzeichnet, daß** die Verstärkungsfunktion (11) einen Verstärkungsfaktor besitzt, der größer als hundert ist.

## Claims

1. Sigma-delta modulator having an input terminal (100a) and an output terminal (100b), comprising:
- a direct pathway linking the input terminal (100a) of the modulator (100) to the output terminal (100b) of the modulator (100) and comprising in succession an amplification block (10) comprising an amplification function (11) of gain (G) greater than one over a predetermined frequency domain, the input terminal (100a) of the modulator (100) being linked to a first direct input of the amplification block (10), and an analogue/digital converter (40);
- a feedback loop linking the output of the analogue/digital converter (40) to a second inverting input of the amplification block (10) and comprising a digital/analogue converter (60); and exhibiting a propagation delay Δt between the input of the analogue/digital converter (40) and the output of the digital/analogue converter (60);
**characterized in that** the sigma-delta modulator (100) also comprises:
- a subtractor (20) situated in the direct pathway between the amplification block (10) and the analogue/digital converter (40), the output of the amplification block (10) being linked to a first direct input of the subtractor (20), an output of the subtractor (20) being linked to the input of the analogue/digital converter (40);
- a compensation filter (70) situated between the output of the subtractor (20) and a second inverting input of the subtractor (20);
and **in that** if one considers an impulse response (IR) of the modulator (100) at the level of the output of the subtractor (20), to a pulse sent at the level of the output of the subtractor (20), comprising a first part (P1) covering a first interval (I1) of time [0; T [ with T ≥ Δt and a second part (P2) covering a second interval (I2) of time [T; ∞ [, the compensation filter (70) is designed to contribute to the first part (P1) and the amplification block (10) is designed to contribute only to the second part (P2).

2. Modulator according to Claim 1, **characterized in that** the direct pathway comprises, between the output of the analogue/digital converter (40) and the output terminal (100b) of the modulator (100), a filter (50) for cutting out a useful zone in the predetermined frequency domain.

3. Modulator according to Claim 2, **characterized in that** the compensation filter (70) is furthermore designed to contribute to the second part (P2) of the impulse response (IR) in such a way as to have an amplification gain (K) of the compensation filter (70) in the useful zone which is a minimum.

4. Modulator according to any one of the preceding claims, **characterized in that** the direct pathway comprises a sample-and-hold module (30) driven by a sampling frequency and situated between the output of the subtractor (20) and the input of the analogue/digital converter (40), the input (70a) of the compensation filter (70) being linked to the output of the sample-and-hold module (30).

5. Modulator according to Claim 4, **characterized in that** the compensation filter (70) comprises, from the output of the sample-and-hold module (30), one or more sample-and-hold modules (71) in series, resistors (72) situated between the outputs of the sample-and-hold modules (30, 71) and the second inverting input of the subtractor (20), the sample-and-hold modules (30, 71) being driven by the same sampling frequency.

6. Modulator according to Claim 5, **characterized in that** at least one of the said resistors (72) is linked to the second inverting input of the subtractor (20) by an inverter (73).

7. Modulator according to Claim 4, **characterized in that** outside of the sampling instants (ti, tj, tk) of the sample-and-hold module (30), the compensation filter (70) is constructed in such a way as to contribute to the first part (P1) of the impulse response (IR) while avoiding jumps in voltage at the input of the sample-and-hold module (30).

8. Modulator according to one of the preceding claims, **characterized in that** the amplification block (10) comprises a filter (13) for shaping the gain of the amplification function (11) as a function of frequency.

9. Modulator according to one of the preceding claims, **characterized in that** the amplification function (11) has a gain greater than a factor one hundred.
